# FASCICULE DE BREVET EUROPEEN

(11) **EP 1 708 965 B1**
(45) Date de publication et mention de la délivrance du brevet: **15.08.2018**
(21) Numéro de dépôt: 05717664.6
(22) Date de dépôt: 13.01.2005
(51) Int. Cl.: C01D 15/04, C30B 29/12, G01N 23/207

(54) **MONOCHROMATEUR LiF DOPE POUR ANALYSE DES RAYONS X**
DOTIERTER LITHIUMFLUORID-MONOCHROMATOR FÜR DIE RÖNTGENANALYSE
DOPED LITHIUM FLUORIDE MONOCHROMATOR FOR X-RAY ANALYSIS

(30) Priorité: 22.01.2004 FR 0400595
(43) Date de publication de la demande: 11.10.2006
(73) Titulaire: Saint-Gobain Cristaux & Détecteurs, 92400 Courbevoie (FR)
(72) Inventeur: GAUTIER, Guillaume, F-91540 MENNECY (FR); DEROUINEAU, Philippe, F-77167 POLIGNY (FR)
(74) Mandataire: Saint-Gobain Recherche
(86) Numéro de dépôt international: PCT/FR2005/050018
(87) Numéro de publication internationale: WO 2005/075716

(56) Documents cités:
- US-A- 3 248 543
- US-A- 4 121 098
- US-A- 5 622 659
- US-A1- 2003 157 005
- US-B1- 6 442 236
- BARSIS E ET AL: "IONIC CONDUCTIVITY OF MGF2-DOPED LIF CRYSTALS" THE BRITISH CERAMIC PROCEEDINGS, STOKE-ON-TRENT, GB, vol. 9, 1967, pages 203-213, XP008035514 ISSN: 0268-4373
- LILLEY E ET AL: "PRECIPITATION IN LIF CRYSTALS DOPED WITH MGF2" JOURNAL OF MATERIALS SCIENCE, CHAPMAN AND HALL LTD, GB, vol. 2, no. 6, 1967, pages 567-582, XP008035513 ISSN: 0022-2461
- MURALIDHARA RAO S: "THERMOLUMINESCENCE OF QUENCHED LIF SINGLE CRYSTALS" PROCEEDINGS OF THE NUCLEAR PHYSICS AND SOLID STATE PHYSICS SYMPOSIUM, 27 décembre 1970 (1970-12-27), pages 225-230, XP008035515
- MOERNER, W. E. ET AL: "Persistent spectral hole burning for R' color centers in lithium fluoride crystals: statics, dynamics, and external-field effects" PHYSICAL REVIEW B: CONDENSED MATTER AND MATERIALS PHYSICS, vol. 33(8), 1986, pages 5702-5716, XP002329467
- LILLEY E: "DEBYE-HUECKEL INTERACTIONS AND SOLUBILITY IN LIF DOPED WITH MGF2" REACTIVITY OF SOLIDS, ELSEVIER, AMSTERDAM, NL, 1972, pages 56-67, XP008035516 ISSN: 0168-7336
- KESSELI J ET AL INSTITUTE OF ELECTRICAL AND ELECTRONICS ENGINEERS: "AN EXPERIMENTAL ANALYSIS OF A DOPED LITHIUM FLUORIDE DIRECT ABSORPTION SOLAR RECEIVER" MECHANICAL ENERGY STORAGE, THERMAL ENERGY STORAGE, FUEL CELLS, BATTERYENERGY STORAGE - TERRESTRIAL APPLICATIONS, SPACE BATTERY ENERGY STORAGE, SUPERCONDUCTIVITY. DENVER, JULY 31 - AUG. 5, 1988, PROCEEDINGS OF THE INTERSOCIETY ENERGY CONVERSION ENGINE, vol. VOL. 2 CONF. 23, 31 juillet 1988 (1988-07-31), pages 179-185, XP000233036
- KHULUGROV, V. M. ET AL.: "Laser active F-aggregate colour centres in LiF monocrystals doped by divalent impurity cations" JOURNAL OF PHYSICS: CONDENSED MATTER, vol. 11, 1999, pages 7005-7019, XP002329304

## Description

L'invention concerne un fluorure de lithium monocristallin dopé par un ion positif bivalent, l'utilisation dudit monocristal en tant que monochromateur d'un rayonnement X, notamment dans les appareils d'analyse par fluorescence X, diffraction X, dans les microsondes électroniques et dans les microscopes à transmission. Toutes ces techniques d'analyse mettent en oeuvre un cristal monochromateur. Ce cristal recueille le rayonnement X qu'on cherche à analyser et sépare par diffraction selon la loi de Bragg les différentes composantes (ou longueurs d'onde) qu'il contient et les renvoie selon des angles spécifiques. Cette séparation conduit à un ensemble de raies de diffraction. Un détecteur placé sur le chemin de la raie à un angle adéquat prévu par la loi de Bragg convertit le rayonnement X en signal électrique.

Dans le cadre de la présente invention on appelle rayonnement X une onde électromagnétique d'énergie comprise entre 0,1 et 1000 keV, plus particulièrement entre 1 et 100 keV.

Dans les appareils d'analyse précités, le rayonnement X peut avoir différentes origines. A titre d'exemple, l'analyse élémentaire d'un échantillon par fluorescence X est une méthode non-destructive basée sur la détection et l'analyse des rayons X émis par ledit échantillon puis recueillis par un cristal monochromateur diffractant lesdits rayons X selon la loi de Bragg.

Selon cette méthode, l'échantillon est irradié par un faisceau de rayons X de grande énergie (cas d'un spectromètre de fluorescence X) ou par un faisceau d'électrons (cas d'une micro-sondes pouvant par exemple être incorporée dans un microscope électronique à balayage). Ce faisceau primaire excite l'échantillon, lequel émet alors un faisceau secondaire de rayons X, également dit de fluorescence X. Ce rayonnement secondaire de fluorescence X contient des longueurs d'ondes caractéristiques des éléments chimiques contenus dans l'échantillon. Le cristal monochromateur sépare par diffraction les différentes composantes qu'il contient et les renvoie selon des angles spécifiques. Cette séparation conduit à un ensemble de raies de diffraction. Un détecteur placé sur le chemin de la raie à un angle adéquat (la loi de Bragg) convertit le rayonnement de fluorescence X en signal électrique. Des intensités spécifiques peuvent être accumulées pour chaque raie de fluorescence X caractéristique d'un élément chimique contenu dans l'échantillon. On peut ainsi déterminer les concentrations chimiques de différents éléments par référence à un étalonnage préalable.

On attend d'un tel système d'analyse une forte sensibilité aux rayonnements X, ce qui se traduit dans le cas de la fluorescence X par une forte capacité à détecter avec la meilleure précision possible des quantités très faibles d'un élément. La sensibilité est d'autant meilleure que le rayonnement X atteignant le détecteur est intense. Dans le cas de la fluorescence X, cette intensité dépend bien entendu de l'échantillon lui-même, de l'élément chimique visé, de la raie de fluorescence choisie, mais également du monochromateur et du détecteur. En effet, le monochromateur peut être plus ou moins réflecteur vis-à-vis du rayonnement X.

Quelque soit le type d'analyse, on cherche des monochromateurs les plus réflecteurs possible pour perdre le moins possible d'intensité lors de l'étape de diffraction.

La qualité du détecteur est également importante, car il ne sert à rien d'utiliser un monochromateur très réflecteur et renvoyant un rayonnement très intense vers le détecteur si ce dernier est incapable de la mesurer. Le détecteur comprend généralement un scintillateur et un photorécepteur. Le scintillateur convertit en impulsions lumineuses l'énergie de rayon X perdue en s'ionisant. Les impulsions lumineuses sont reçues par un photorécepteur les convertissant en signal électrique. Le photorécepteur est habituellement un tube photomultiplicateur (appelé « PMT »), ou une photodiode ou autre. Le rayonnement X frappant le scintillateur est saturé au delà d'une certaine intensité (i.e. d'un certain nombre de coups reçus dans un laps de temps donné). En effet, après chaque détection de rayonnement X (c'est-à-dire chaque comptage d'une impulsion), le scintillateur présente un temps de relaxation (« decay time » en anglais) pendant lequel toute autre détection est impossible. Un scintillateur courant comme l'iodure de sodium dopé au thallium (Nal(TI)), présente un temps de relaxation d'environ 230 ns. Celui-ci est évalué par calage d'une loi en somme (ou intégrale) d'exponentielles sur le signal du scintillateur en fonction du temps: on ne donne par convention et dans la suite du texte que le temps de relaxation relatif à la composante lumineuse majoritaire. Avec un tel scintillateur, le taux de comptage maximum est d'environ 4 millions d'interactions par seconde. En pratique cette valeur est généralement à diviser par 2. Dans de nombreux cas, du fait du temps de relaxation important du scintillateur, un filtre doit atténuer l'intensité du rayonnement X.

L'article BARSIS E ET AL, "IONIC CONDUCTIVITY OF MGF2-DOPED LIF CRYSTALS", THE BRITISH CERAMIC PROCEEDINGS, STOKE-ON-TRENT, GB, (1967), vol. 9, ISSN 0268-4373, pages 203 - 213, XP008035514, décrit un échantillon cristallin de fluorure de lithium dopé avec 0,077% en moles de MgF2, ce qui correspond à 0,0297 mole de Mg par kg de LiF. Il s'agit d'un cristal contenant des précipitations.

Selon l'invention, on a découvert d'une part qu'un monocristal de LiF dopé par un ion positif bivalent, utilisé comme monochromateur présentait un fort pouvoir réflecteur et d'autre part que le fort rayonnement issu du monochromateur pouvait être efficacement reçu par un scintillateur lumineux et rapide, par exemple du type halogénure de terre rare.

L'invention concerne un appareil d'analyse comprenant un monochromateur constitué d'un fluorure de lithium monocristallin dopé par au moins 0,018 moles par kg d'un ion positif bivalent choisi parmi Mg²⁺, Co²⁺ ou Zn²⁺, présent à l'état fluoré, ou par au moins 0,018 moles par kg d'un mélange d'au moins deux ions choisis parmi Mg²⁺, Co²⁺ ou Zn²⁺ présent à l'état fluoré. De préférence, le fluorure monochromateur de l'appareil d'analyse contient au moins 0,02 mole et même au moins 0,023 mole et même au moins 0,025 mole d'ion positif bivalent ou de mélange d'ions par kg de fluorure. Le fluorure monochromateur de l'appareil d'analyse comprend généralement au plus 0,082 mole et encore plus généralement au plus 0,045 mole d'ion positif bivalent ou de mélange d'ions par kg de fluorure.

L'invention concerne également un fluorure de lithium monocristallin dopé par 0,023 à 0,082 moles par kg d'un ion positif bivalent choisi parmi Mg²⁺, Co²⁺ ou Zn²⁺, présent à l'état fluoré, ou par 0,023 à 0,082 moles par kg d'un mélange d'au moins deux ions choisis parmi Mg²⁺, Co²⁺ ou Zn²⁺ présent à l'état fluoré. De préférence, le fluorure contient au moins 0,025 mole d'ion positif bivalent ou de mélange d'ions par kg de fluorure. Le fluorure comprend généralement au plus 0,045 mole d'ion positif bivalent ou de mélange d'ions par kg de fluorure.

L'ion M, M étant un ion positif bivalent choisi parmi Mg²⁺, Co²⁺ ou Zn²⁺, ou étant un mélange d'au moins deux ions choisis parmi Mg²⁺, Co²⁺ ou Zn²⁺, est présent dans le fluorure de lithium LiF sous forme fluoré, c'est-à-dire MF₂. Les teneurs en M sont données en moles de M (et non pas en moles de MF₂) par kilo total de fluorure dopé, c'est-à-dire par kilo de fluorure contenant Li et M (et non pas de LiF pur). L'ion M est de préférence Mg²⁺. Le tableau ci-dessous donne quelques caractéristiques de ces ions.

| | Mg²⁺ | Co²⁺ | Zn²⁺ |
|---|---|---|---|
| Numéro atomique | 12 | 27 | 30 |
| Rayon ionique (picomètres) | 65 | 72 | 74 |

Le tableau suivant donne les équivalences entre des teneurs en M exprimées en moles par kg et des teneurs en Mg²⁺, Co²⁺ ou Zn²⁺ exprimées en ppm en poids.

| M (mole / kg) | Mg²⁺ (ppm en poids) | Co²⁺ (ppm en poids) | Zn²⁺ (ppm en poids) |
|---|---|---|---|
| 0,018 | 438 | 1060 | 1177 |
| 0,020 | 486 | 1179 | 1308 |
| 0,023 | 559 | 1355 | 1504 |
| 0,025 | 608 | 1473 | 1635 |
| 0,045 | 1094 | 2652 | 2942 |
| 0,082 | 1993 | 4832 | 5361 |

Les concentrations en M peuvent être analysées par spectrométrie ICP (Spectrométrie d'émission optique à plasma, « Induction Coupled Plasma » en anglais).

Si le fluorure selon l'invention comprend trop de M (au dessus de 0,045 mole de M par kg), le monocristal peut devenir fragile et des cassures peuvent être observées.

Le LiF peut être fabriqué à l'état de monocristal à partir de poudres de LiF pur et de MgF₂ pur, CoF₂ pur, ZnF₂ pur. Les poudres sont placées dans un creuset compatible avec son contenu, généralement un creuset en platine ou en graphite. L'ensemble est ensuite chauffé jusqu'à fusion des poudres, généralement entre 800 et 1000 °C, plus particulièrement au dessus du point de fusion du LiF, lequel est d'environ 870°C et l'on procède ensuite à la cristallisation congruente menant à un monocristal ou un ensemble de quelques gros monocristaux. La technique de cristallisation peut être la méthode de Czochralski, de Kyropoulos ou de Bridgman-Stockbarger. Cette dernière technique mène généralement à un polycristal contenant de gros monocristaux (volume des monocristaux de l'ordre de 1 à 10 cm³). Les méthodes de Czochralski et de Kyropoulos mènent à des monocristaux et font intervenir un germe. Le germe peut être en LiF pur ou en LiF dopé par M.

Le matériau obtenu par ces méthodes de croissance est ensuite exploité pour obtenir des monocristaux ayant généralement la forme de cube ou parallélépipèdes dont l'épaisseur va de 0,05 mm à 10 mm d'épaisseur et dont les deux surfaces parallèles principales (dont l'une est destinée à recevoir et réfléchir le rayonnement X) présentent une surface allant de 0,5 à 30 cm². La préparation de ces pièces monocristallines peut être faite à partir du matériau issu directement de la croissance, par exemple par clivage (essentiellement selon le plan cristallin (200)).

Dans le cas d'une utilisation dans un spectromètre séquentiel, on prépare généralement un parallélépipède d'épaisseur allant de 1 à 10 mm , dont la surface peut être obtenue par clivage ou plus généralement par érosion mécanique avec un abrasif ou par érosion mécanique et chimique.

Dans le cas d'une utilisation dans un spectromètre simultané, on prépare généralement des lames minces parallélépipédiques, généralement clivées, d'épaisseur allant de 0,05 à 1 mm auxquelles on impose une forme en général concave par application sur un support concave. Dans ce cas, le monochromateur a également une action focalisante. Ainsi, dans le cadre de l'invention, on prépare et utilise des monocristaux individuels (non aggloméré à un autre monocristal) dont le volume va de 2,5.10⁻³ cm³ à 30 cm³ et plus généralement de 0,01 à 20 cm³.

On a observé que l'intensité réfléchie par le monocristal LiF : M selon l'invention (notamment quand M est Mg) augmente très fortement lorsque la longueur d'onde de la raie réfléchie diminue, notamment pour les longueur d'onde inférieures à 3 Å et même inférieures à 2 Å et même inférieures à 1,5 Å. L'invention concerne également un procédé d'analyse d'un élément à l'aide d'un appareil d'analyse comprenant un monochromateur constitué du fluorure selon l'invention ainsi qu'un scintillateur couplé audit monochromateur, ledit scintillateur étant calé sur une raie de longueur d'onde inférieure à 3 Å, voire inférieure à 2 Å, voire inférieure à 1,5 Å.

L'augmentation d'intensité réfléchie par le monocristal LiF :M selon l'invention est particulièrement spectaculaire avec l'augmentation de la teneur en M, en particulier aux courtes longueurs d'onde. Cette influence de la longueur d'onde est plus particulièrement observée pour un état de surface clivé. Pour un état de surface préparé par érosion mécanique (par exemple par un abrasif comme le carbure de silicium, le carbure de bore, le diamant) ou même par érosion mécanique et chimique, on observe également une augmentation d'intensité réfléchie par le monocristal LiF :M selon l'invention (moins spectaculaire que dans le cas de la surface clivée) en particulier aux courtes longueurs d'onde.

Le gain en intensité (plan cristallographique (200)) est conservé après courbure des lames monocristallines planes, notamment dans le cas d'un état de surface clivé.

Sans que la demanderesse ne soit tenue par aucune considération théorique, les propriétés de réflectivité aux rayons X pourraient être imputées à des insertions ou substitutions de M (comme Mg²⁺) dans le réseau cationique. L'invention concerne donc du LiF dopé avec au moins un ion bivalent M comme Mg²⁺ et de rayon ionique voisin de celui de Li⁺ (60 picomètres), en particulier Mg²⁺, Co²⁺ et Zn²⁺. Ces ions offrent l'avantage d'un numéro atomique encore faible (donc offrant une plus faible absorption aux X) et ont sous la forme de fluorures (notamment MgF₂, CoF₂, ZnF₂) des propriétés physiques compatibles avec la fusion du LiF (fusion à 1200°C et 872°C respectivement, ébullition à 1400°C et 1500°C respectivement).

L'invention concerne également la combinaison du monocristal LiF :M selon l'invention comme monochromateur avec un détecteur comprenant un scintillateur rapide (temps de relaxation inférieur à 30 ns sur sa composante principale) et permettant des comptages d'au moins 10 millions de coups par seconde. On utilise également de préférence un scintillateur présentant une bonne résolution de son spectre en énergie. La résolution en énergie (ΔE/E) est usuellement déterminée pour un détecteur donné à une énergie incidente donnée, comme la largeur à mi-hauteur du pic considéré sur un spectre en énergie obtenu à partir de ce détecteur, rapportée à l'énergie de la centroïde du pic (voir notamment : G.F. Knoll, « Radiation detection and measurement » John Wiley and Sons, Inc, 2nd édition, p 114). Cette combinaison selon l'invention augmente le nombre de photons de fluorescence X analysées. La statistique d'analyse est ainsi améliorée. Le résultat, pour l'appareil d'analyse, est une meilleure qualité d'analyse et une diminution du temps de mesure.

Comme scintillateur adapté, on peut utiliser un matériau polycristallin ou monocristallin comprenant un halogénure de terre rare. Ces cristaux présentent l'avantage d'avoir à la fois un temps de relaxation court (par exemple 28 ns pourLa_{0,9}Ce_{0,1}Cl₃, chiffre obtenu par calage sur modèle exponentiel simple) et une bonne résolution en énergie (3.9% sous Cs137). Comme halogénures de terre rare plus particulièrement concernés on peut notamment citer:
- ALn₂X₇ dans laquelle Ln représente une ou plusieurs terre rare(s), X représente un ou plusieur(s) atome(s) d'halogène choisi parmi Cl, Br ou I, A représentant un alcalin comme Rb et Cs,
- LaCl₃ pouvant notamment être dopé par 0,1 à 50 % en poids de CeCl₃,
- LnBr₃ pouvant notamment être dopé par 0,1 à 50 % en poids de CeBr₃,
- LaBr₃ pouvant notamment être dopé par 0,1 à 50 % en poids de CeBr₃,
- GdBr₃ pouvant notamment être dopé par 0,1 à 50 % en poids de CeBr₃,
- LaₓLn₍₁₋ₓ₎X₃ pouvant notamment être dopé par 0,1 à 50 % de CeX₃, x pouvant aller de 0 à 1, Ln étant une terre rare différente de La, X étant un halogène comme précédemment dit,
- LaₓGd₍₁₋ₓ₎Br₃ pouvant notamment être dopé par 0,1 à 50 % en poids de CeBr₃, x pouvant aller de 0 à 1,
- LaₓLu₍₁₋ₓ₎Br₃ pouvant notamment être dopé par 0,1 à 50 % en poids de CeBr₃, x pouvant aller de 0 à 1,
- Ln'ₓLn"₍₁₋ₓ₎X'_{3(1-y)}X"_{3y} dans laquelle Ln' et Ln" sont deux terres rares différentes du type Ln, X' et X" étant deux halogènes différents du type X, notamment Cl et Br, x pouvant aller de 0 à 1, y pouvant aller de 0 à 1,
- RbGd₂Br₇ pouvant notamment être dopé par 0,1 à 50 % en poids de CeBr₃,
- RbLn₂Cl₇ pouvant notamment être dopé par 0,1 à 50 % en poids de CeCl₃,
- RbLn₂Br₇ pouvant notamment être dopé par 0,1 à 50 % en poids de CeBr₃,
- CsLn₂Cl₇ pouvant notamment être dopé par 0,1 à 50 % en poids de CeCl₃,
- CsLn₂Br₇ pouvant notamment être dopé par 0,1 à 50 % en poids de CeBr₃,
- K₂LaCl₅ pouvant notamment être dopé par 0,1 à 50 % en poids de CeCl₃.
- K₂LaI₅ pouvant notamment être dopé par 0,1 à 50 % en poids de CeI₃.
- LuI₃ pouvant notamment être dopé par 0,1 à 50 % en poids de CeI₃.

Le terme « dopant » ou « dopé » se réfère à une terre rare minoritaire se substituant à une ou plusieurs terres rares majoritaires, les minoritaires et majoritaires étant compris sous le sigle Ln.

Comme halogénure de terre rare préférés, on peut citer :
LaBr₃ dopé par 5 à 15% en poids de CeCl₃,
LaCl₃ dopé par 5 à 15% en poids de CeCl₃.

L'invention n'est pas limitée à l'utilisation d'un cristal de Nal(TI), ou d'halogénure de lanthane comme détecteur. Des détecteurs donnant lieu à une bonne résolution en énergie (notamment sur une large plage énergétique) et/ou un bon temps de réponse (notamment inférieur à 100 ns) peuvent utilement être employées en combinaison avec le cristal de LiF selon l'invention. De tels cristaux peuvent par exemple être YAP (Pérovskite d'Yttrium et d'Aluminium) notamment dopé Ce (), ou YAG (Grenat d'Yttrium et d'Aluminium) ou Ge (Germanium)

### EXEMPLES

On a préparé des monocristaux de LiF purs ou dopés au Mg sous forme fluorée à partir d'un mélange homogène de poudres de LiF pur et de MgF₂ pur en différentes concentrations. Le mélange était placé dans un creuset en platine, puis fondu par chauffage à 950°C. On a ensuite procédé à une cristallisation qui à mené à un monocristal de 2300 cm³.

L'intensité du rayonnement X réfléchi a été mesurée sur des morceaux monocristallins clivés selon le plan (200), avec la raie K_{α} du Molybdène. L'intensité varie peu dans une gamme de concentration en Mg entre 0 et 400 ppm en poids. L'intensité des LiF :Mg fortement dopés en magnésium est exprimée en pourcentage de l'intensité de l'échantillon à 300 ppm en poids de Mg. Le tableau 1 rassemble ces résultats. Dans ce tableau, le nom des échantillons contient la teneur en Mg.

**Tableau 1**

| Echantillon | Teneur en Mg (ppm en poids) | Teneur en Mg (mole par kg) | % d'intensité par rapport à LiF₃₀₀ |
|---|---|---|---|
| LiF pur | 0 | 0 | 100 % |
| LiF₃₀₀ | 300 | 0,0123 | 100 % |
| LiF₅₀₁ | 501 | 0,0206 | 336 % |
| LiF₆₆₄ | 664 | 0,0273 | 476 % |
| LiF₇₆₅ | 765 | 0,0314 | 552 % |
| LiF₁₀₆₃ | 1063 | 0,0437 | 589 % |

L'influence de la longueur d'onde sur l'intensité réfléchie a également été mesurée sur des échantillons à teneur différente en Mg. Le tableau 2 rassemble les résultats. Ces résultats sont exprimés en % de l'intensité réfléchie pour le LiF₃₀₀. L'intensité réfléchie augmente très fortement lorsque la longueur d'onde diminue pour les échantillons à plus forte teneur en Mg.

**Tableau 2**

| | λ = 3,359 Å | λ = 2,750 Å | λ = 1,937 Å | λ = 1,542 Å | λ = 0,7107 Å |
|---|---|---|---|---|---|
| | Ca | Ti | Fe | Cu | Mo |
| LiF₃₀₀ | 100% | 100% | 100% | 100% | 100% |
| LiF₇₆₅ | 207% | 252% | 358% | 410% | 572% |
| LiF₁₀₆₃ | 238% | 285% | 404% | 441% | 595% |

Le gain en intensité mesuré à l'état de surface clivé (plan cristallographique (200)) est conservé après courbure des lames planes. Par exemple, à la longueur d'onde du fer (λ = 1,937 Å), l'intensité réfléchie par le LiF₆₆₄ plan clivé est 2,8 fois plus élevée que celle du LiF₃₀₀ plan clivé. L'intensité réfléchie par les lames LiF₆₆₄ courbées sur un cylindre dont l'axe est parallèle à la direction des rayons X reste plus élevée que l'intensité réfléchie par les lames LiF₃₀₀ également courbées sur un même cylindre d'axe parallèle à la direction des rayons X. Le rapport d'intensité des lames courbées sur un cylindre d'axe parallèle au faisceau de rayons X est resté le même (2,8).

## Revendications

1. Appareil d'analyse comprenant un monochromateur constitué d'un fluorure de lithium monocristallin dopé par au moins 0,018 moles par kg d'un ion positif bivalent choisi parmi Mg²⁺, Co²⁺ ou Zn²⁺, présent à l'état fluoré, ou par au moins 0,018 moles par kg d'un mélange d'au moins deux ions choisis parmi Mg²⁺, Co²⁺ ou Zn²⁺ présent à l'état fluoré.

2. Appareil selon la revendication précédente **caractérisé en ce que** l'ion positif bivalent ou le mélange d'ions est présent dans le fluorure à raison d'au moins 0,02 moles par kg.

3. Appareil selon la revendication précédente **caractérisé en ce que** l'ion positif bivalent ou le mélange d'ions est présent dans le fluorure à raison d'au moins 0,023 moles par kg.

4. Appareil selon la revendication précédente **caractérisé en ce que** l'ion positif bivalent ou le mélange d'ions est présent dans le fluorure à raison d'au moins 0,025 moles par kg.

5. Appareil selon l'une des revendications précédentes, **caractérisé en ce que** l'ion positif bivalent ou le mélange d'ions est présent dans le fluorure à raison d'au plus 0,082 moles par kg.

6. Appareil selon la revendication précédente **caractérisé en ce que** l'ion positif bivalent ou le mélange d'ions est présent dans le fluorure à raison d'au plus 0,045 moles par kg.

7. Appareil selon l'une des revendications précédentes, **caractérisé en ce que** l'ion positif bivalent est Mg²⁺.

8. Appareil selon l'une des revendications 1 à 7, **caractérisé en ce que** l'ion positif bivalent est Co²⁺.

9. Appareil selon l'une des revendications 1 à 7, **caractérisé en ce que** l'ion positif bivalent est Zn²⁺.

10. Appareil selon l'une des revendications précédentes **caractérisé en ce que** le fluorure se présente sous la forme d'un cube ou parallélépipède.

11. Appareil selon l'une des revendications précédentes, **caractérisé en ce que** le volume du fluorure va de 2,5.10⁻³ cm³ à 30 cm³.

12. Appareil selon la revendication précédente, **caractérisé en ce que** le volume du fluorure va de 0,01 à 20 cm³.

13. Appareil selon l'une des revendications précédentes, **caractérisé en ce que** le fluorure présente une surface clivée.

14. Appareil selon l'une des revendications précédentes **caractérisé en ce que** le fluorure présente une surface rodée puis traités en milieu acide ou polie.

15. Appareil selon l'une des revendications précédentes **caractérisé en ce qu'**il comprend au moins un scintillateur comprenant un halogénure de terre rare.

16. Appareil selon la revendication précédente **caractérisé en ce que** l'halogénure de terre rare est LaCl₃ dopé au CeCl₃ ou LaBr₃ dopé au CeBr₃.

17. Procédé d'analyse d'un élément d'un échantillon à l'aide d'un appareil de l'une des revendications d'appareil précédentes, **caractérisé en ce que** ledit appareil comprend un détecteur comprenant un scintillateur, ledit scintillateur étant calé sur une raie de longueur d'onde inférieure à 3 Å.

18. Procédé selon la revendication précédente, **caractérisé en ce que** le scintillateur est calé sur une raie de longueur d'onde inférieure à 2 Å.

19. Procédé selon la revendication précédente, **caractérisé en ce que** le scintillateur est calé sur une raie de longueur d'onde inférieure à 1,5 Å.

20. Fluorure de lithium monocristallin dopé par 0,023 à 0,082 moles par kg d'un ion positif bivalent choisi parmi Mg²⁺, Co²⁺ ou Zn²⁺, présent à l'état fluoré, ou par 0,023 à 0,082 moles par kg d'un mélange d'au moins deux ions choisis parmi Mg²⁺, Co²⁺ ou Zn²⁺ présent à l'état fluoré.

21. Fluorure selon la revendication précédente **caractérisé en ce que** l'ion positif bivalent ou le mélange d'ions est présent à raison d'au moins 0,025 moles par kg.

22. Fluorure selon la revendication précédente **caractérisé en ce que** l'ion positif bivalent ou le mélange d'ions est présent à raison d'au plus 0,045 moles par kg.

23. Fluorure selon l'une des revendications 20 à 22, **caractérisé en ce que** l'ion positif bivalent est Mg²⁺.

24. Fluorure selon l'une des revendications 20 à 22, **caractérisé en ce que** l'ion positif bivalent est Co²⁺.

25. Fluorure selon l'une des revendications 20 à 22, **caractérisé en ce que** l'ion positif bivalent est Zn²⁺.

26. Fluorure selon l'une des revendications 20 à 25, **caractérisé en ce qu'**il se présente sous la forme d'un cube ou parallélépipède.

27. Fluorure selon l'une des revendications 20 à 26, **caractérisé en ce que** son volume va de 2,5.10⁻³ cm³ à 30 cm³.

28. Fluorure selon la revendication précédente, **caractérisé en ce que** son volume va de 0,01 à 20 cm³.

29. Fluorure selon l'une des revendications 20 à 28, **caractérisé en ce qu'**il présente une surface clivée.

30. Fluorure selon l'une des revendications 20 à 28, **caractérisé en ce qu'**il présente une surface rodée puis traités en milieu acide ou polie.

31. Utilisation d'un fluorure de l'une des revendications 20 à 30 comme monochromateur.

## Patentansprüche

1. Analysegerät mit einem Monochromator, der aus einem monokristallinen Lithiumfluorid gebildet ist, das mit mindestens 0,018 Mol je kg eines positiv zweiwertigen Ions, das unter Mg²⁺, Co²⁺ oder Zn²⁺ gewählt ist, das im fluorierten Zustand vorliegt, oder mit mindestens 0,018 Mol je kg eines Gemisches aus mindestens zwei Ionen, die unter Mg²⁺, Co²⁺ oder Zn²⁺ gewählt sind, das im fluorierten Zustand vorliegt, dotiert ist.

2. Gerät nach dem vorhergehenden Anspruch, **dadurch gekennzeichnet, dass** das positiv zweiwertige Ion oder das lonengemisch in dem Fluorid im Verhältnis von mindestens 0,02 Mol je kg vorliegt.

3. Gerät nach dem vorhergehenden Anspruch, **dadurch gekennzeichnet, dass** das positiv zweiwertige Ion oder das lonengemisch in dem Fluorid im Verhältnis von mindestens 0,023 Mol je kg vorliegt.

4. Gerät nach dem vorhergehenden Anspruch, **dadurch gekennzeichnet, dass** das positiv zweiwertige Ion oder das lonengemisch in dem Fluorid im Verhältnis von mindestens 0,025 Mol je kg vorliegt.

5. Gerät nach einem der vorhergehenden Ansprüche, **dadurch gekennzeichnet, dass** das positiv zweiwertige Ion oder das lonengemisch in dem Fluorid im Verhältnis von höchstens 0,082 Mol je kg vorliegt.

6. Gerät nach dem vorhergehenden Anspruch, **dadurch gekennzeichnet, dass** das positiv zweiwertige Ion oder das lonengemisch in dem Fluorid im Verhältnis von höchstens 0,045 Mol je kg vorliegt.

7. Gerät nach einem der vorhergehenden Ansprüche, **dadurch gekennzeichnet, dass** das positiv zweiwertige Ion Mg²⁺ ist.

8. Gerät nach einem der Ansprüche 1 bis 7, **dadurch gekennzeichnet, dass** das positiv zweiwertige Ion Co²⁺ ist.

9. Gerät nach einem der Ansprüche 1 bis 7, **dadurch gekennzeichnet, dass** das positiv zweiwertige Ion Zn²⁺ ist.

10. Gerät nach einem der vorhergehenden Ansprüche, **dadurch gekennzeichnet, dass** das Fluorid in Form eines Würfels oder Parallelepipeds vorliegt.

11. Gerät nach einem der vorhergehenden Ansprüche, **dadurch gekennzeichnet, dass** das Volumen des Fluorids 2,5.10⁻³ cm³ bis 30 cm³ beträgt.

12. Gerät nach dem vorhergehenden Anspruch, **dadurch gekennzeichnet, dass** das Volumen des Fluorids 0,01 bis 20 cm³ beträgt.

13. Gerät nach einem der vorhergehenden Ansprüche, **dadurch gekennzeichnet, dass** das Fluorid eine gespaltene Fläche aufweist.

14. Gerät nach einem der vorhergehenden Ansprüche, **dadurch gekennzeichnet, dass** das Fluorid eine geschliffene und anschließend in saurem Milieu behandelte oder polierte Fläche aufweist.

15. Gerät nach einem der vorhergehenden Ansprüche, **dadurch gekennzeichnet, dass** es mindestens einen Szintillator umfasst, der ein Seltenerdhalogenid umfasst.

16. Gerät nach dem vorhergehenden Anspruch, **dadurch gekennzeichnet, dass** das Seltenerdhalogenid mit CeCl₃ dotiertes LaCl₃ oder mit CeBr₃ dotiertes LaBr₃ ist.

17. Verfahren zur Analyse eines Elements einer Probe mithilfe eines Geräts eines der vorhergehenden Geräteansprüche, **dadurch gekennzeichnet, dass** das Gerät einen Detektor umfasst, der einen Szintillator umfasst, wobei der Szintillator auf eine Wellenlängenlinie kleiner als 3 Å eingestellt ist.

18. Verfahren nach dem vorhergehenden Anspruch, **dadurch gekennzeichnet, dass** der Szintillator auf eine Wellenlängenlinie kleiner als 2 Å eingestellt ist.

19. Verfahren nach dem vorhergehenden Anspruch, **dadurch gekennzeichnet, dass** der Szintillator auf eine Wellenlängenlinie kleiner als 1,5 Å eingestellt ist.

20. Monokristallines Lithiumfluorid, das mit 0,023 bis 0,082 Mol je kg eines positiv zweiwertigen Ions, das unter Mg²⁺, Co²⁺ oder Zn²⁺ gewählt ist, das im fluorierten Zustand vorliegt, oder mit 0,023 bis 0,082 Mol je kg eines Gemisches aus mindestens zwei Ionen, die unter Mg²⁺, Co²⁺ oder Zn²⁺ gewählt sind, das im fluorierten Zustand vorliegt, dotiert ist.

21. Fluorid nach dem vorhergehenden Anspruch, **dadurch gekennzeichnet, dass** das positiv zweiwertige Ion oder das lonengemisch im Verhältnis von mindestens 0,025 Mol je kg vorliegt.

22. Fluorid nach dem vorhergehenden Anspruch, **dadurch gekennzeichnet, dass** das positiv zweiwertige Ion oder das lonengemisch im Verhältnis von höchstens 0,045 Mol je kg vorliegt.

23. Fluorid nach einem der Ansprüche 20 bis 22, **dadurch gekennzeichnet, dass** das positiv zweiwertige Ion Mg²⁺ ist.

24. Fluorid nach einem der Ansprüche 20 bis 22, **dadurch gekennzeichnet, dass** das positiv zweiwertige Ion Co²⁺ ist.

25. Fluorid nach einem der Ansprüche 20 bis 22, **dadurch gekennzeichnet, dass** das positiv zweiwertige Ion Zn²⁺ ist.

26. Fluorid nach einem der Ansprüche 20 bis 25, **dadurch gekennzeichnet, dass** es in Form eines Würfels oder Parallelepipeds vorliegt.

27. Fluorid nach einem der Ansprüche 20 bis 26, **dadurch gekennzeichnet, dass** sein Volumen 2,5.10⁻³ cm³ bis 30 cm³ beträgt.

28. Fluorid nach dem vorhergehenden Anspruch, **dadurch gekennzeichnet, dass** sein Volumen 0,01 bis 20 cm³ beträgt.

29. Fluorid nach einem der Ansprüche 20 bis 28, **dadurch gekennzeichnet, dass** es eine gespaltene Fläche aufweist.

30. Fluorid nach einem der Ansprüche 20 bis 28, **dadurch gekennzeichnet, dass** es eine geschliffene und anschließend in saurem Milieu behandelte oder polierte Fläche aufweist.

31. Verwendung eines Fluorids eines der Ansprüche 20 bis 30 als Monochromator.

## Claims

1. An analyzer comprising a monochromator made of a monocrystalline lithium fluoride doped by at least 0.018 moles per kg of a bivalent positive ion selected from Mg2+, Co2+ or Zn2+, present in the fluorinated state, or by at least 0.018 moles per kg of a mixture of at least two ions selected from Mg2+, Co2+ or Zn2+ present in the fluorinated state.

2. An analyser as claimed in preceding claim, **characterized in that** the bivalent positive ion or the mixture of ions is present in the fluoride in an amount of at least 0.02 mol/kg.

3. An analyser as claimed in preceding claim, **characterized in that** the bivalent positive ion or the mixture of ions is present in the fluoride in an amount of at least 0.023 mol/kg.

4. An analyser as claimed in preceding claim, **characterized in that** the bivalent positive ion or the mixture of ions is present in the fluoride in an amount of at least 0.025 mol/kg.

5. An analyser as claimed in one of the preceding claims, **characterized in that** the bivalent positive ion or the mixture of ions is present in the fluoride in an amount of at most 0.082 mol/kg.

6. An analyser as claimed in preceding claim, **characterized in that** the bivalent positive ion or the mixture of ions is present in the fluoride in an amount of at most 0.045 mol/kg.

7. An analyser as claimed in one of the preceding claims, **characterized in that** the bivalent positive ion is Mg2+.

8. An analyser as claimed in one of claims 1 to 7, **characterized in that** the bivalent positive ion is Co2+.

9. An analyser as claimed in one of claims 1 to 7, **characterized in that** the bivalent positive ion is Zn2+.

10. An analyser as claimed in one of the preceding claims, **characterized in that** the fluoride is in the form of a cube or parallelepiped.

11. An analyser as claimed in one of the preceding claims, **characterized in that** the volume of the fluoride ranges from 2.5 × 10⁻³ cm³ to 30 cm³.

12. An analyser as claimed in preceding claim, **characterized in that** the volume of the fluoride ranges from 0.01 to 20 cm³.

13. An analyser as claimed in one of the preceding claims, **characterized in that** the fluoride has a cleaved surface.

14. An analyser as claimed in one of the preceding claims, **characterized in that** the fluoride has a lapped surface that is then treated in acid medium or polished.

15. An analyser as claimed in one of the preceding claims, **characterized in that** it includes at least one scintillator containing a rare-earth halide.

16. An analyser as claimed in preceding claim, **characterized in that** the rare-earth halide is CeCl₃-doped LaCl₃ or CeBr₃-doped LaBr₃.

17. A method of analysis for an element of a specimen using an analyzer as claimed in one of the preceding claims of analyzer, **characterized in that** the scintillator is locked onto a line having a wavelength of less than 3 Å.

18. The method as claimed in the preceding claim, **characterized in that** the scintillator is locked onto a line having a wavelength of less than 2 Å.

19. The method as claimed in the preceding claim, **characterized in that** the scintillator is locked onto a line having a wavelength of less than 1.5 Å.

20. A single-crystal lithium fluoride doped with 0.023 to 0.082 moles per kg of a bivalent positive ion selected from Mg2+, Co2+ or Zn2+, present in the fluorinated state, or 0.023 to 0.082 moles per kg of a mixture of at least two ions selected from Mg2+, Co2+ or Zn2+, present in the fluorinated state.

21. A fluoride as claimed in the preceding claim, **characterized in that** the bivalent positive ion or the mixture of ions is present in an amount of at least 0.025 mol/kg.

22. A fluoride as claimed in preceding claim, **characterized in that** the bivalent positive ion or the mixture of ions is present in the fluoride in an amount of at most 0.045 mol/kg.

23. A fluoride as claimed in one of claims 20 to 22, **characterized in that** the bivalent positive ion is Mg2+.

24. A fluoride as claimed in one of claims 20 to 22, **characterized in that** the bivalent positive ion is Co2+.

25. A fluoride as claimed in one of claims 20 to 22, **characterized in that** the bivalent positive ion is Zn2+.

26. A fluoride as claimed in one of claims 20 to 25, **characterized in that** it is in the form of a cube or parallelepiped

27. A fluoride as claimed in one of claims 20 to 26, **characterized in that** its volume ranges from 2.5 × 10⁻³ cm³ to 30 cm³.

28. A fluoride as claimed in preceding claim, **characterized in that** its volume ranges from 0.01 to 20 cm³.

29. A fluoride as claimed in one of claims 20 to 28, **characterized in that** it has a cleaved surface.

30. A fluoride as claimed in one of claims 20 to 28, **characterized in that** it has a lapped surface that is then treated in acid medium or polished.

31. The use of a fluoride as claimed in one of claims 20 to 30 as monochromator.
